Europäisches Patentamt

European Patent Office

Office européen des brevets

(19)

(11) Veröffentlichungsnummer: **0 128 631 B1**

(12) **EUROPÄISCHE PATENTSCHRIFT**

(45) Veröffentlichungstag der Patentschrift: **04.12.91**

(51) Int. Cl.5: **H03K 5/02, H03K 17/62**

(21) Anmeldenummer: **84200851.8**

(22) Anmeldetag: **13.06.84**

(54) **Schaltungsanordnung aus einem Verstärker und einem elektronischen Umschalter.**

(30) Priorität: **14.06.83 DE 3321354**

(43) Veröffentlichungstag der Anmeldung:
**19.12.84 Patentblatt 84/51**

(45) Bekanntmachung des Hinweises auf die
Patenterteilung:
**04.12.91 Patentblatt 91/49**

(84) Benannte Vertragsstaaten:
**DE FR GB IT SE**

(56) Entgegenhaltungen:
**US-A- 3 194 985**
**US-A- 3 654 394**
**US-A- 4 363 033**

**U. Tietze, Ch. Schenk,**
**"Halbleiterschaltungstechnik", 5. Auflage,**
**Springer-Verlag Berlin 1980, Seiten 640-641**

(73) Patentinhaber: **Philips Patentverwaltung**
**GmbH**
**Wendenstrasse 35 Postfach 10 51 49**
**W-2000 Hamburg 1(DE)**

(84) Benannte Vertragsstaaten:
**DE**

Patentinhaber: **N.V. Philips' Gloeilampenfa-**
**brieken**
**Groenewoudseweg 1**
**NL-5621 BA Eindhoven(NL)**

(84) Benannte Vertragsstaaten:
**FR GB IT SE**

(72) Erfinder: **Buchholz, Werner, Dipl.-Ing.**
**Peter-Vischer-Strasse 16**
**W-8560 Lauf(DE)**

(74) Vertreter: **Peuckert, Hermann, Dipl.-Ing. et al**
**Philips Patentverwaltung GmbH Wenden-**
**strasse 35 Postfach 10 51 49**
**W-2000 Hamburg 1(DE)**

**Beschreibung**

Die Erfindung betrifft eine Schaltungsanordnung aus einem Verstärker und einem mittels Schaltdioden realisierten elektronischen Umschalter am Eingang des Verstärkers gemäß dem Oberbegriff des Anspruchs 1.

In Dietrich Elias, Telekommunikation in der Bundesrepublik Deutschland, 1982, R. v. Decker's Verlag, G. Schenck, Heidelberg, Hamburg, 1982, Seite 206 bis 208 ist ein Leitungsendgerät für ein PCM-Übertragungssystem beschrieben. Das Leitungsendgerät ist mit einem automatisch geregelten Schnittstellenverstärker ausgestattet, der die ankommenden verzerrten PCM-Signale entzerrt. Die Dämpfung auf der Leitung darf dabei bis zu 12 dB bei 70 MHz betragen. Damit bei Bedarf von der Betriebsleitung auf eine Ersatzleitung umgeschaltet werden kann, ist am Eingang des Schnittstellenverstärkers ein elektronischer Umschalter vorgesehen, der entweder von Hand oder ferngesteuert betätigt wird.

Aus den amerikanischen Patentschriften US 3,194,985 und US 4,363,033 sind Schaltungsanordnungen bekannt, mit denen eine von mehreren Eingangsleitungen über Umschalter auf den Eingang eines Verstärkers geschaltet werden.

Der Betriebsstrom für den hierfür erforderlichen Umschalter wird bei der US-A-3,194,985 über ein Widerstandsnetzwerk von einer zusätzlichen Hilfsspannungsquelle unter Verwendung von Schalter-Dioden eingespeist.

Bei der US-A-4,363,033 ist ebenfalls eine Hilfsspannungsquelle vorgesehen, die den Betriebsstrom für den Umschalter am Eingang des Verstärkers liefert, wobei die Ableitung des Betriebsstromes des Umschalters über ein RC-Netzwerk erfolgt.

Aus U. Tietze, Ch. Schenk, "Halbleiterschaltungstechnik", 5. Auflage, Springer-Verlag Berlin, 1980, Seiten 640 bis 641 ist es bekannt, bei einem Digital-Analog-Wandler mit gesteuerter Stromumschaltung den Betriebsstrom für den elektronischen Umschalter am Eingang eines Operationsverstärkers über einen Gegenkopplungswiderstand dem Ausgang des Verstärkers zu entnehmen. Die Einspeisung des Betriebsstromes erfolgt mit Hilfe von Schalterdioden, an deren Anoden Steuerspannungen angelegt werden können.

Aufgabe der Erfindung ist es deshalb, eine Schaltungsanordnung der eingangs genannten Art anzugeben, die wegen der geforderten hohen Betriebszuverlässigkeit einen geringen Aufwand an aktiven und passiven Bauelementen benötigt, deren Leistungsaufnahme gering ist und die besonders zur Realisierung in Hybridtechnik geeignet ist und keine zusätzlichen Hilfsspannungsquellen benötigt.

Die Erfindung löst diese Aufgabe durch die kennzeichnenden Merkmale des Anspruchs 1.

In den Unteransprüchen sind vorteilhafte Ausgestaltungen der Erfindung angegeben.

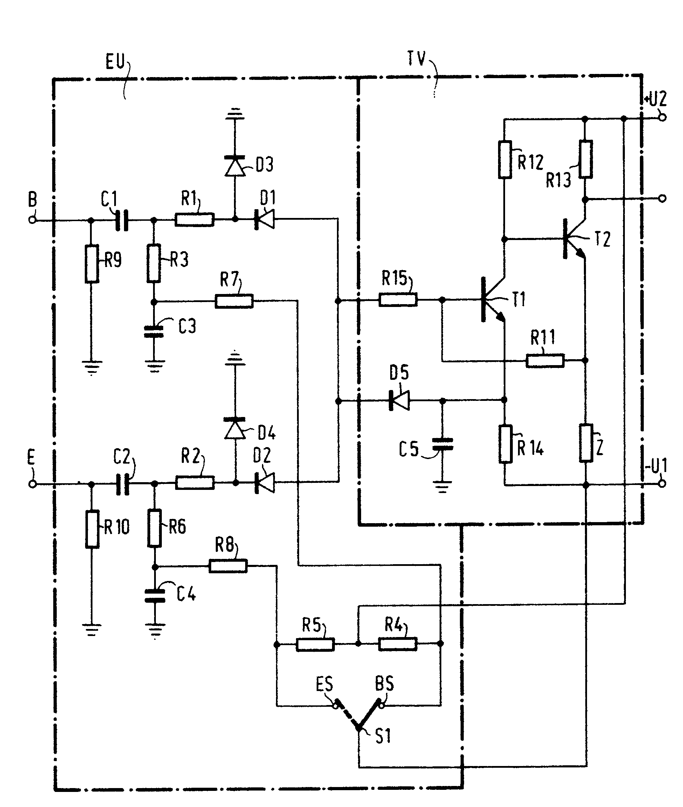

Die Figur zeigt ein Ausführungsbeispiel der Erfindung, bei dem auf einen von zwei Übertragungswegen umgeschaltet werden kann. Beim Ausführungsbeispiel in der Figur sind die Eingänge für die beiden Übertragungswege mit B und E bezeichnet. An die Eingänge B und E ist je ein Kabel angeschlossen, das als Übertragungsmedium dient.

Zunächst wird der elektronische Umschalter EU und im Anschluß daran der zweistufige Transistorverstärker TV beschrieben.

Der Eingang B liegt über einen Widerstand R9 und parallel dazu über eine Reihenschaltung aus einer Kapazität C1, einem Widerstand R3 und einer weiteren Kapazität C3 an Bezugspotential (Masse). Vom Verbindungspunkt der Kapazität C1 und des Widerstandes R3 führt ein Widerstand R1 zur Anode einer Diode D3 und zur Katode einer Diode D1.

Der Eingang E liegt über einen Widerstand R10 und parallel dazu über eine Reihenschaltung aus einer Kapazität C2, einem Widerstand R6 und einer weiteren Kapazität C4 an Bezugspotential. Vom Verbindungspunkt der Kapazität C2 und des Widerstandes R6 führt ein Widerstand R2 zur Anode einer Diode D4 und zur Katode einer Diode D2. Die Katoden der Dioden D3 und D4 liegen an Bezugspotential. Die Anoden der beiden Dioden D1 und D2 sind miteinander verbunden.

Vier hintereinandergeschaltete Widerstände R7, R4, R5 und R8 führen in der angegebenen Reihenfolge vom Verbindungspunkt des Widerstandes R3 und der Kapazität C3 zum Verbindungspunkt des Widerstandes R6 und der Kapazität C4. Über einen Umschalter S1, der entweder von Hand geschaltet oder ferngesteuert wird, liegt die Versorgungsspannung -U1 je nach seiner Stellung entweder am Verbindungspunkt der beiden Widerstände R7 und R4 oder am Verbindungspunkt der beiden Widerstände R8 und R5. Der Verbindungspunkt der beiden Widerstände R4 und R5 liegt dagegen an der Versorgungsspannung +U2.

Der zweistufige Transistorverstärker TV ist folgendermaßen aufgebaut.

Die Basis eines Transistors T1 ist über einen Gegenkopplungswiderstand R11 mit dem Emitter eines Transistors T2 verbunden, dessen Basis mit dem Kollektor des Transistors T1 verbunden ist. Der Kollektor des Transistors T1 liegt über einen Widerstand R12 und der Kollektor des Transistors T2 über einen Widerstand R13 an der Versorgungsspannung +U2. Dagegen liegen der Emitter des Transistors T1 über einen Widerstand R14 und der Emitter des Transistors T2 über einen Widerstand Z an der Versorgungsspannung -U1. Außerdem liegt der Emitter des Transistors T1 über eine Kapazität C5 an Bezugspotential. Dem Kollektor des Transistors T2 wird das Ausgangssignal entnommen.

Die miteinander verbundenen Anoden der beiden Dioden D1 und D2, die zum elektronischen Umschalter EU gehören, sind über einen Widerstand R15 mit der Basis und über eine Diode D5 mit dem Emitter des Transistors T1, der zum Transistorverstärker TV gehört, verbunden. Dabei ist die Anode der Diode D5 an den Emitter des Transistors T1 angeschlossen, während ihre Katode an die Anoden der Dioden D1 und D2 angeschlossen ist.

In der Stellung BS, die der Umschalter S1 in der Figur hat, ist der Eingang B durchgeschaltet, während der Eingang E gesperrt ist. Der Betriebsstrom für den elektronischen Umschalter EU wird über den Gegenkopplungswiderstand R11 der Endstufe des Transistorverstärkers V entnommen. Er fließt von +U2 über den Widerstand R13, die Kollektor-Emitter-Strecke des Transistors T2, den Gegenkopplungswiderstand R11, den Widerstand R15, die Diode D1, die Widerstände R1, R3 und R7 sowie über den Umschalter S1 nach -U1. Die Diode D1 wird deshalb in den niederohmigen Zustand gesteuert, ohne daß hierzu zusätzliche Steuerleistung erforderlich ist, die über weitere Bauelemente an HF-mäßig kritische Punkte der Schaltungsanordnung geführt werden müßte. Damit die Diode D3 sperrt, wird das Potential an der Basis des Transistors T1 auf einen Wert eingestellt, der zwischen -U1 und Bezugspotential liegt. Wenn z.B. -U1 4,5V und +U2 5V beträgt, wird die Diode D3 bei einem Potential von -0,8V an der Basis des Transistors T1 mit einer Sperrspannung von 1,8V betrieben.

Es sind deshalb keine zusätzlichen Hilfsspannungsquellen nötig, um Sperrspannungen für die Dioden zu erzeugen. Die Basis des Transistors T1 stellt wegen der HF-mäßigen Gegenkopplung den fiktiven $R_i$-Nullpunkt des Transistorverstärkers TV dar. Welche Vorteile dadurch erzielt werden, wird an späterer Stelle erläutert.

Wenn der Umschalter S1 in der Stellung BS ist, fließt ein Strom von +U2 über die Widerstände R5, R8, R6 und R2 sowie über die Diode D4 zu dem Knoten, der auf Bezugspotential liegt. Die Diode D4 ist deshalb im niederohmigen Zustand, während die Diode D2 gesperrt ist, denn an ihr liegt bei den angegebenen Werten für -U1 (-4,5V), für +U2 (+5V) und für das Potential an der Basis des Transistors T1 (-0,8V) eine Sperrspannung von 1,6V, so daß auch hier ohne zusätzliche Bauelemente die Einstellung geeigneter Potentialverhältnisse ermöglicht wird.

Um den Eingang E anzuschalten und den Eingang B zu sperren, wird der Umschalter S1 von der Stellung BS in die Stellung ES geschaltet. Die Umschaltung kann von Hand oder ferngesteuert erfolgen. An den Dioden D1, D2, D3 und D4 kehren sich die Spannungsverhältnisse um: Nun sind die Dioden D2 und D3 leitend, während die Dioden D1 und D4 gesperrt sind. Der Betriebsstrom für den elektronischen Umschalter EU fließt, wie bereits beschrieben, von +U2 zum Widerstand R15 und von dort weiter über die Diode D2, die Widerstände R2, R6 und R8 sowie über den Umschalter S1 nach -U1. Den Strompfad für den Strom zum Sperren des Eingangs B bilden die Widerstände R4, R7, R3 und R1 sowie die Diode D3.

Die Eingänge E und B des elektronischen Umschalters EU sind gleich aufgebaut. Die folgenden Bauteile entsprechen einander und haben jeweils die gleichen Werte: R9 und R10, R1 und R2, R3 und R6, R7 und R8, R4 und R5, C1 und C2, C3 und C4, D1 und D2 sowie D3 und D4.

Wenn z.B. auf einen von n Übertragungswegen umgeschaltet werden soll, so sind hierzu n gleiche Eingänge parallel zu schalten. Der Umschalter S1 ist dann als ein Umschalter mit n Schaltmöglichkeiten ausgeführt.

Unabhängig davon, welcher von den beiden Eingängen B und E gesperrt und welcher zum Transistorverstärker TV durchgeschaltet ist, sind die Kabel an diesen beiden Eingängen immer mit einem ausreichend hohen Scheinwiderstand abgeschlossen. Ist z.B. der Eingang B zum Transistorverstärker TV durchgeschaltet, so liegt das Kabel am Eingang B HF-mäßig über den Widerstand R1, die Diode D1, den Widerstand R15 und den fiktiven $R_i$-Nullpunkt des Transistorverstärkers TV sowie parallel dazu über den Widerstand R3 und die Kapazität C3 auf Bezugspotential. Das Kabel am gesperrten Eingang E liegt über den Widerstand R6 und die Kapazität C4 sowie parallel dazu über den Widerstand R2 und die Diode D4 HF-mäßig auf Bezugspotential. Der Widerstand R15, der niederohmig gewählt ist, hat lediglich die Funktion eines Schwingschutzwiderstandes. Wählt man R3≪R1 und R6≪R2, so sind beide Kabel immer mit nahezu dem gleichen Widerstand HF-mäßig abgeschlossen, denn der Verbindungspunkt der beiden Dioden D1 und D3 bzw. D2 und D4 liegt im durchgeschalteten Zustand niederohmig gegen R1 bzw. R2 durch den fiktiven $R_i$-Nullpunkt des Transistorverstärkers TV und im gesperrten Zustand über die Diode D3 bzw. D4 auf Bezugspotential. Damit ist in beiden Fällen der Eingangswiderstand im wesentlichen durch die Parallelschaltung der Widerstände R1 und R3 bzw. R2 und R6 bestimmt.

Die hochohmigen Widerstände R1 und R2 dienen außerdem in Verbindung mit den Dioden D3 und D4 dem Schutz vor positiven Überspannungen gegenüber Bezugspotential, so daß die als Umschaltdioden wirkenden Dioden D3 und D4 gleichzeitig auch als Schutzdioden wirksam sind. Zum Schutz gegen negative Überspannungen an den beiden Eingängen genügt eine Schutzdiode, die Diode D5, wobei die hochohmigen Widerstände R1 und R2 zusätzlich eine wirkungsvolle Strombegrenzung darstellen.

Weil die beiden Eingänge B und E am fiktiven $R_i$-Nullpunkt des Transistorverstärkers TV zusammengeführt sind, sind sie besonders gut gegeneinander entkoppelt.

Aus folgenden zwei Gründen ist das angegebene Ausführungsbeispiel besonders dafür geeignet, in Hybridtechnik realisiert zu werden: Es benötigt keine Induktivitäten, um Steuersignale für den elektronischen Umschalter EU einzuspeisen. Aufgrund der schon erläuterten Anordnung der Dioden D1, D2, D3 und D4 am fiktiven $R_i$-Nullpunkt ist der HF-Pegel an ihnen gering.

Das Übersprechen an den beiden Eingangen B und E wird dadurch wirkungsvoll unterdrückt, obwohl bei dem dichten Aufbau in Hybridtechnik die Streukapazitäten der Dioden mit ihren Kontaktierungsflecken wesentlich größer sind als die der Substratwiderstände. Dadurch werden auch bei Frequenzen über 200 MHz hohe Sperrdämpfungen erzielt. Für die Dioden D1, D2, D3 und D4 sind Tuner-Dioden besonders geeignet, weil sie bei einem Strom von etwa 2 mA einen Durchlaßwiderstand von ungefähr 1 Ohm aufweisen, und weil sie sich durch geringe Sperrkapazitäten von etwa 1 pF bei kleinen Sperrspannungen auszeichnen.

Anstelle des Widerstandes Z kann im Transistorverstärker TV ein Regelnetzwerk vorgesehen werden, das die zum komplexen Frequenzgang der Leitung inverse Übertragungsfunktion erzeugt, damit eine automatische Pulsentzerrung durchgeführt werden kann.

**Patentansprüche**

1.  Schaltungsanordnung aus einem Verstärker (TV) und einem mittels Schaltdioden realisierten elektronischen Umschalter (EU) am Eingang des Verstärkers (TV) zum Umschalten auf einen von mehreren Übertragungswegen für Hochfrequenzsignale, wobei die Ableitung des Betriebsstromes der Schaltdioden über ein RC-Netzwerk (R1, R3, C3, R7, R4, R2, R6, C4, R8, R5) erfolgt.
    dadurch gekennzeichnet, daß der Verstärker einen gegen kopplungswiderstand (R11) zwischen Eingang und einem Ausgang des Verstärkers aufweist, und die Schaltdioden (D1,D2) daß der Betriebsstrom für über den Gegenkopplungswiderstand (R11) dem Ausgang des Verstärkers (TV) entnommen wird.

2.  Schaltungsanordnung nach Anspruch 1, dadurch gekennzeichnet, daß die Eingänge (B, $\overline{E}$)

des elektronischen Umschalters (EU) gleich aufgebaut sind.

3.  Schaltungsanordnung nach Anspruch 2, dadurch gekennzeichnet, daß der elektronische Umschalter (EU) zwei Eingänge (B, E) aufweist.

4.  Schaltungsanordnung nach Anspruch 3, dadurch gekennzeichnet, daß der eine Eingang (B) des elektronischen Umschalters (EU) über eine Reihenschaltung aus einem ersten Widerstand (R1), aus einer ersten und einer zweiten Diode (D1, D2), die entgegengesetzt gepolt sind, und einem zweiten Widerstand (R2) mit dem anderen Eingang (E) verbunden ist, daß der eine Eingang (B) parallel dazu über eine Reihenschaltung aus einem dritten, vierten, fünften und sechsten Widerstand (R3, R4, R5, R6) mit dem anderen Eingang (E) verbunden ist, daß am Verbindungspunkt des dritten und vierten Widerstandes (R3, R4) der eine Ausgang (BS) eines Umschalters (S1) angeschlossen ist, daß am Verbindungspunkt des fünften und sechsten Widerstandes (R5, R6) der andere Ausgang (ES) des Umschalters (S1) angeschlossen ist, dessen Eingang an einer ersten Versorgungsspannung (-U1) liegt, daß der Verbindungspunkt des vierten und fünften Widerstandes (R4, R5) an einer zweiten Versorgungsspannung (+U2) liegt, daß der Verbindungspunkt des ersten Widerstandes (R1) und der ersten Diode (D1) über eine dritte Diode (D3), die entgegengesetzt zur ersten Diode (D1) gepolt ist, auf Bezugspotential liegt, daß der Verbindungspunkt des zweiten Widerstandes (R2) und der zweiten Diode (D2) über eine vierte Diode (D4), die entgegengesetzt zur zweiten Diode (D2) gepolt ist, auf Bezugspotential liegt, daß die miteinander verbundenen gleichen Elektroden der ersten und der zweiten Diode (D1, D2) den Ausgang des elektronischen Umschalters (EU) bilden, in den der Betriebsstrom über den Gegenkopplungswiderstand (R11) eingespeist wird, daß das Potential an den miteinander verbundenen entgegengesetzten Elektroden der ersten und dritten Diode (D1, D3) entgegengesetzt zum Potential an den miteinander verbundenen entgegengesetzten Elektroden der zweiten und vierten Diode (D2, D4) ist.

5.  Schaltungsanordnung nach Anspruch 4, dadurch gekennzeichnet, daß zwischen dem dritten und vierten Widerstand (R3, R4) ein siebter Widerstand (R7) und zwischen dem fünften und sechsten Widerstand (R5, R6) ein achter Widerstand (R8) liegt.

6. Schaltungsanordnung nach Anspruch 5, dadurch gekennzeichnet, daß zwischen dem ersten Widerstand (R1) und dem einen Eingang (B) des elektronischen Umschalters (EU) eine erste Kapazität (C1) liegt und daß zwischen dem zweiten Widerstand (R2) und dem anderen Eingang (E) des elektronischen Umschalters (EU) eine zweite Kapazität (C2) liegt.

7. Schaltungsanordnung nach Anspruch 5 oder 6, dadurch gekennzeichnet, daß der eine Eingang (B) des elektronischen Umschalters (EU) über einen neunten Widerstand (R9) auf Bezugspotential liegt und daß der andere Eingang (E) des elektronischen Umschalters (EU) über einen zehnten Widerstand (R10) auf Bezugspotential liegt.

8. Schaltungsanordnung nach Anspruch 5, 6 oder 7, dadurch gekennzeichnet, daß der Verbindungspunkt des dritten und siebten Widerstandes (R3, R7) über eine dritte Kapazität (C3) auf Bezugspotential liegt und daß der Verbindungspunkt des sechsten und achten Widerstandes (R6, R8) über eine vierte Kapazität (C4) auf Bezugspotential liegt.

9. Schaltungsanordnung nach Anspruch 4, 5, 6, 7 oder 8, dadurch gekennzeichnet, daß die Anoden der ersten und zweiten Diode (D1, D2) miteinander verbunden sind, daß die erste Versorgungsspannung (-U1) negativ und die zweite Versorgungsspannung (+U2) positiv gegenüber Bezugspotential ist.

10. Schaltungsanordnung nach Anspruch 4, 5, 6, 7, 8 oder 9, dadurch gekennzeichnet, daß der Umschalter (S1) von Hand oder ferngesteuert betätigbar ist.

11. Schaltungsanordnung nach einem der vorangehenden Ansprüche, dadurch gekennzeichnet, daß der Verstärker ein zweistufiger, über beide Stufen gegengekoppelter Transistorverstärker (TV) ist und daß die miteinander verbundenen Elektroden der ersten und der zweiten Diode (D1, D2) an die Basis des Eingangstransistors (T1) des Transistorverstärkers (TV) angeschlossen sind.

12. Schaltungsanordnung nach Anspruch 11, dadurch gekennzeichnet, daß der Basis des Eingangstransistors (T1) des Transistorverstärkers (TV) ein elfter Widerstand (R15) vorgeschaltet ist.

**Claims**

1. Circuit arrangement comprising an amplifier (TV) and an electronic selector switch (EU) realised by means of switching diodes at the input of the amplifier (TV) for switching to one out of a plurality of transmission paths for high-frequency signals, the operating current of the switching diodes being derived through an RC network (R1, R3, C3, R7, R4, R2, R6, C4, R8, R5), characterized in that the amplifier comprises a negative feedback resistor (R11) between the input and an output of the amplifier, and in that the operating current for the switching diodes (D1, D2) is taken from the output of the amplifier (TV) through a negative feedback resistor (R11).

2. Circuit arrangement as claimed in Claim 1, characterized in that the inputs (B, E) of the electronic selector switch (EU) are of identical structure.

3. Circuit arrangement as claimed in Claim 2, characterized in that the electronic selector switch (E,U) has two inputs (B, E).

4. Circuit arrangement as claimed in Claim 3, characterized in that one input (B) of the electronic selector switch (EU) is connected to the other input (E) through a series arrangement of a first resistor (R1), first and second diodes (D1, D2) whose polarities are reversed and a second resistor (R2), in that said one input (B) is connected parallel to above series arrangement to said other input (E) through a series arrangement comprising third, fourth, fifth and sixth resistors (R3, R4, R5, R6), in that one output (BS) of a selector switch (S1) is connected to the junction of the third and fourth resistors (R3, R4), the other output (ES) of the selector switch (S1) to the junction of the fifth and sixth resistors (R5, R6), and the input of the selector switch is connected to a first supply voltage (-U1), in that the junction of the fourth and fifth resistors (R4, R5) is connected to a second supply voltage (+U2), in that the junction of the first resistor (R1) and the first diode (D1) is connected to reference potential across a third diode (D3) whose polarity is reversed relative to the rust diode (D1), in that the junction of the second resistor (R2) and the second diode (D2) is connected to reference potential across a fourth diode (D4) whose polarity is reversed relative to the second diode (D2), in that the interconnected identical electrodes of the first and second diodes (D1, D2) form the output of the electronic selector switch (EU) to which the operating current is fed through the negative feedback resistor (R11), in that the potential at the interconnected opposite electrodes of the first and third diodes (D1, D3) is opposite to the potential at the interconnected opposite electrodes of the second and fourth diodes (D2, D4).

5. Circuit arrangement as claimed in Claim 4, characterized in that a seventh resistor (R7) is arranged between the third and fourth resistors (R3, R4) and an eighth resistor (R8) between the fifth and sixth resistors (R5, R6).

6. Circuit arrangement as claimed in Claim 5, characterized in that a first capacitor (C1) is inserted between the first resistor (R1) and said one input (B) of the electronic selector switch (EU) and in that a second capacitor (C2) is inserted between the second resistor (R2) and said other input (E) of the electronic selector switch (EU).

7. Circuit arrangement as claimed in Claim 5 or 6, characterized in that said one input (B) of the electronic selector switch (EU) is connected to reference potential through a ninth resistor (R9) and in that said other input (E) of the electronic selector switch (EU) is connected to reference potential through a tenth resistor (R10).

8. Circuit arrangement as claimed in Claim 5, 6 or 7, characterized in that the junction of the third and seventh resistors (R3, R7) is connected to reference potential across a third capacitor (C3) and in that the junction between the sixth and eighth resistors (R6, R8) is connected to reference potential across a fourth capacitor (C4).

9. Circuit arrangement as claimed in Claim 4, 5, 6, 7 or 8, characterized in that the anodes of the first and second diodes (D1, D2) are interconnected, in that the first supply voltage (-U1) is negative and the second supply voltage (+U2) is positive with respect to reference potential.

10. Circuit arrangement as claimed in Claim 4, 5, 6, 7, 8 or 9, characterized in that the selector switch (S1) can be operated manually or remotely.

11. Circuit arrangement as claimed in any of the preceding Claims, characterized in that the amplifier is a two-stage transistor amplifier (TV) having a negative feedback over both stages and in that the interconnected electrodes of the first and second diodes (D1, D2) are connected to the base of the input transistor (T1) of the transistor amplifier (TV).

12. Circuit arrangement as claimed in Claim 11, characterized in that the base of the input transistor (T1) of the transistor amplifier (TV) is preceded by an eleventh resistor (R15).

**Revendications**

1. Montage de circuit formé d'un amplificateur (TV) et d'un commutateur électronique (EU) réalisé au moyen de diodes de commutation, à l'entrée de l'amplificateur (TV), pour commuter sur l'une de plusieurs voies de transmission pour des signaux à haute fréquence, la dérivation du courant de service des diodes de commutation s'effectuant par l'intermédiaire d'un montage RC (R1, R3, C3, R7, R4, R2, R6, C4, R8, R5), caractérisé en ce que l'amplificateur comporte une résistance de contre-réaction (R11) entre l'entrée et une sortie de l'amplificateur et que le courant de service pour les diodes de commutation (D1, D2) est prélevé, par l'intermédiaire de la résistance de contre-réaction (R11), de la sortie de l'amplificateur (TV).

2. Montage de circuit suivant la revendication 1, caractérisé en ce que les entrées (B, E) du commutateur électronique (EU) sont de même structure.

3. Montage de circuit suivant la revendication 2, caractérisé en ce que le commutateur électronique (EU) comporte deux entrées (B, E).

4. Montage de circuit suivant la revendication 3, caractérisé en ce que l'une des entrées (B) du commutateur électronique (EU) est connectée, par l'intermédiaire d'un montage en série d'une première résistance (R1), d'une première et d'une deuxième diode (D1, D2), qui sont connectées en opposition, et d'une deuxième résistance (R2) à l'autre entrée (E), que l'une des entrées (B) est connectée en parallèle, par l'intermédiaire d'un montage en série d'une troisième, d'une quatrième, d'une cinquième et d'une sixième résistance (R3, R4, R5, R6), à l'autre entrée (E), qu'au point de connexion des troisième et quatrième résistances (R3, R4) est connectée l'une des sorties (BS) d'un commutateur (S1), qu'au point de connexion des cinquième et sixième résistances (R5, R6) est connectée l'autre sortie (ES) du commutateur (S1), dont l'entrée est connectée à une première tension d'alimentation (-U1), que le point de connexion des quatrième et cinquième résistances (R4, R5) est connecté à une deuxième tension d'alimentation (+U2), que le point de connexion de la première résistance (R1) et de la première diode (D1) est connecté au potentiel de référence, par l'intermédiaire d'une troisième diode (D3) qui est connectée en opposition à la première diode (D1), que le point de connexion de la deuxième résistance (R2) et de la deuxième diode (D2) est connecté au potentiel de référence, par l'intermédiaire d'une quatrième diode (D4) qui est connectée en opposition à la deuxième diode (D2), que les mêmes électrodes connectées l'une à l'autre de la première et de la deuxième diode (D1, D2) forment la sortie du commutateur électronique (EU), dans lequel le courant de service est introduit par l'intermédiaire de la résistance de contre-réaction (R11), que le potentiel aux électrodes opposées connectées l'une à l'autre de la première et de la troisième diode (D1, D3) est opposé au potentiel des électrodes opposées connectées l'une à l'autre de la deuxième et de la quatrième diode (D2, D4).

5. Montage de circuit suivant la revendication 4, caractérisé en ce qu'entre la troisième et la quatrième résistance (R3, R4) est installée une septième résistance (R7) et entre la cinquième et la sixième résistance (R5, R6), une huitième résistance (R8).

6. Montage de circuit suivant la revendication 5, caractérisé en ce qu'entre la première résistance (R1) et l'une des entrées (B) du commutateur électronique (EU) est prévue une première capacité (C1) et qu'entre la deuxième résistance (R2) et l'autre entrée (E) du commutateur électronique (EU) est prévue une deuxième capacité (C2).

7. Montage de circuit suivant la revendication 5 ou 6, caractérisé en ce que l'une des entrées (B) du commutateur électronique (EU) est connectée, par l'intermédiaire d'une neuvième résistance (R9), au potentiel de référence et que l'autre entrée (E) du commutateur électronique (EU) est connectée au potentiel de référence, par l'intermédiaire d'une dixième résistance (R10).

8. Montage de circuit suivant la revendication 5, 6 ou 7, caractérisé en ce que le point de connexion de la troisième et de la septième résistance (R3, R7) est connecté au potentiel de référence, par l'intermédiaire d'une troisième capacité (C3) et que le point de connexion de la sixième et de la huitième résistance (R6, R8) est connecté au potentiel de référence, par l'intermédiaire d'une quatrième capacité (C4).

9. Montage de circuit suivant la revendication 4, 5, 6, 7 ou 8, caractérisé en ce que les anodes de la première et de la deuxième diode (D1, D2) sont interconnectées, que la première tension d'alimentation (-U1) est négative et que la seconde tension d'alimentation (+U2) est positive par rapport au potentiel de référence.

10. Montage de circuit suivant la revendication 4, 5, 6, 7, 8 ou 9, caractérisé en ce que le commutateur (S1) peut être actionné à la main ou par télécommande.

11. Montage de circuit suivant l'une quelconque des revendications précédentes, caractérisé en ce que l'amplificateur est un amplificateur à transistors à deux étages (TV) à contre-réaction sur les deux étages et que les électrodes interconnectées de la première et de la deuxième diode (D1, D2) sont connectées à la base du transistor d'entrée (T1) de l'amplificateur à transistors (TV).

12. Montage de circuit suivant la revendication 11, caractérisé en ce que la base du transistor d'entrée (T1) de l'amplificateur à transistors (TV) est précédée d'une onzième résistance (R15).